(19) Europäisches Patentamt
European Patent Office
Office européen des brevets

(11) **EP 3 176 597 A2**

(12) **EUROPEAN PATENT APPLICATION**

(43) Date of publication:
**07.06.2017 Bulletin 2017/23**

(51) Int Cl.:
**G01R 33/58** (2006.01)

(21) Application number: **16194310.5**

(22) Date of filing: **18.10.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **02.12.2015 CN 201510873905**

(71) Applicant: **Shenyang Neusoft Medical Systems Co., Ltd.**
**Shenyang Liaoning 110179 (CN)**

(72) Inventors:
• **SHI, Jianhua**
  **Shenyang, Liaoning 110179 (CN)**
• **HU, Hongbing**
  **Shenyang, Liaoning 110179 (CN)**

• **LI, Haiquan**
  **Shenyang, Liaoning 110179 (CN)**
• **WU, Lin**
  **Shenyang, Liaoning 110179 (CN)**
• **WNAG, Hongwei**
  **Shenyang, Liaoning 110179 (CN)**
• **SUN, Rong**
  **Shenyang, Liaoning 110179 (CN)**
• **WANG, Yan**
  **Shenyang, Liaoning 110179 (CN)**
• **ZUO, Hong**
  **Shenyang, Liaoning 110179 (CN)**

(74) Representative: **Grünecker Patent- und Rechtsanwälte**
**PartG mbB**
**Leopoldstraße 4**
**80802 München (DE)**

(54) **CALIBRATING RADIO FREQUENCY POWER OF MAGNETIC RESONANCE IMAGING SYSTEM**

(57)     A method of calibrating a RF power of a magnetic resonance imaging system is provided. With a fixed time-domain length of RF pulses, a RF pulse amplitude having a larger step size increment is selected to perform a traversal scanning to obtain FID signal values corresponding to different RF pulse amplitudes. In subsequent traversal scanning, the step size is continuously scaled down, and a start value and an end value are re-determined to continuously narrow a range for the subsequent traversal scanning, which may quickly and accurately determine a RF pulse amplitude corresponding to a 90° flip angle that can be obtained from a RF pulse amplitude corresponding to a maximum FID signal value in a last traversal scanning. A linear relationship between a flip angle and a RF pulse amplitude is obtained according to the 90° flip angle and its corresponding RF pulse amplitude for calibrating a RF power.

FIG. 1

**Description**

**TECHNICAL FIELD**

The present disclosure is directed to calibrating a radio frequency (RF) power of a magnetic resonance imaging (MRI) system.

**BACKGROUND**

A magnetic resonance imaging (MRI) system utilizes combined pulsed gradient magnetic fields and pulsed radio frequency (RF) magnetic fields to obtain MR1 information of spin protons in a designated imaging region corresponding to an imaging sample placed in a static magnetic field. A net magnetic moment exists in the magnetized spin protons placed in the static magnetic field, wherein a direction of the net magnetic moment is a spin axis direction of the spin protons. The spin axis direction of the spin protons is always inclined to an axis direction $\overline{B}_0$ of the external static magnetic field, and the individual spin proton always performs a precession motion around the axis direction of the static magnetic field with a Larmor frequency that is equal to a Gyromagnetic ratio multiplied by a magnetic induction intensity of the static magnetic field.

In order to obtain detectable magnetic resonance signals, a RF excitation field having a Larmor frequency may be applied such that the net magnetic moment of the spin protons may deviate from the axis direction of the static magnetic field, wherein the deviation angle, i.e., the flip angle, is proportional to the applied RF pulse amplitude and a duration of the RF pulse. After stopping applying the RF excitation pulse, the spin protons may restore to a normal spin status. During this period, the spin protons may generate a free induction decay (FID) signal having the same frequency with the RF excitation pulse. The FID signal is received by a RF reception coil, and is then amplified and processed for reconstructing a magnetic resonance medical image.

As can be seen, when the magnetic resonance imaging system is operating, it may require the net magnetic moment formed by the spin protons to perform a precession motion according to a specific flip angle, which may need to determine the RF pulse power for flipping the net magnetic moment according to the specific flip angle. If the RF field intensity and the duration of the RF excitation pulse are abnormal, it may lead to deviations in the flip angle, which may further reduce the intensity of the received magnetic resonance signal and a signal-to-noise ratio. Imaging quality problems, such as artifacts, may exist in the reconstructed image.

NEUSOFT MEDICAL SYSTEMS CO., LTD. (NMS), founded in 1998 with its world headquarters in China, is a leading supplier of medical equipment, medical IT solutions, and healthcare services. NMS supplies medical equipment with a wide portfolio, including CT, Magnetic Resonance Imaging (MRI), digital X-ray machine, ultrasound, Positron Emission Tomography (PET), Linear Accelerator (LINAC), and biochemistry analyser. Currently, NMS' products are exported to over 60 countries and regions around the globe, serving more than 5,000 renowned customers. NMS's latest successful developments, such as 128 Multi-Slice CT Scanner System, Superconducting MRI, LINAC, and PET products, have led China to become a global high-end medical equipment producer. As an integrated supplier with extensive experience in large medical equipment, NMS has been committed to the study of avoiding secondary potential harm caused by excessive X-ray irradiation to the subject during the CT scanning process.

**SUMMARY**

One aspect of the present disclosure provides a method of calibrating a radio frequency (RF) power of a magnetic resonance imaging system. The method may comprise: determining a first start value, a first end value and a first step size regarding amplitudes of RF pulses which are to be applied in a first traversal scanning; performing the first traversal scanning according to the first start value, the first end value and the first step size with a fixed time-domain length of the RF pulses, so as to obtain free induction decay (FID) signal values corresponding to different RF pulse amplitudes in the first traversal scanning, wherein the FID signal values obtained in the first traversal scanning constitute a first FID signal set having an uptrend segment and a downtrend segment; performing a traversal parameter setting for determining a n-th start value, a n-th end value and a n-th step size regarding amplitudes of RF pulses which are to be applied in a n-th traversal scanning, wherein n is a positive integer greater than or equal to 2, the n-th start value is a RF pulse amplitude corresponding to an FID signal value of an uptrend segment of a (n-1)-th FID signal set obtained in a (n-1)-th traversal scanning, the n-th end value is a RF pulse amplitude corresponding to an FID signal value of a downtrend segment of the (n-1)-th FID signal set, the n-th start value is greater than or equal to a (n-1)-th start value of the (n-1)-th traversal scanning, the n-th end value is less than or equal to a (n-1)-th end value of the (n-1)-th traversal scanning, and the n-th step size is less than a (n-1)-th step size of the (n-1)-th traversal scanning; performing the n-th traversal scanning according to the n-th start value, the n-th end value and the n-th step size with the fixed time-domain length of the RF pulses, so as to obtain FID signal values corresponding to different RF pulse amplitudes in the n-th traversal scanning, wherein the FID signal values obtained in the n-th traversal scanning constitute a n-th FID signal set having a corresponding uptrend segment and a corresponding downtrend segment; determining whether the n-th traversal scanning is a last traversal scanning according to a default end condition; and if the n-th traversal scanning is determined to be the last traversal scanning according to the default end condition, determining a linear relationship between a flip angle and a RF pulse amplitude according to a 90o flip angle and a corresponding RF pulse amplitude, wherein the RF pulse amplitude corresponding to the 90o flip angle is obtained from a RF pulse amplitude corresponding to a maximum FID signal value in the last traversal scanning.

Another one aspect of the present disclosure provides a scanning method for a magnetic resonance imaging system. The method may comprise: obtaining a linear relationship between a flip angle and a RF pulse amplitude by adopting the above method of calibrating a radio frequency (RF) power of a magnetic resonance imaging system, in a case that a subject is located in a magnetic resonance imaging system; and performing a scanning to the subject by using a RF pulse amplitude determined based on the linear relationship.

Another one aspect of the present disclosure provides a device for calibrating a RF power of a magnetic resonance imaging system. The device may comprises a processor which invokes machine readable instructions corresponding to a control logic for calibrating a RF power stored on a storage medium and executes the machine readable instructions to: determine a first start value, a first end value and a first step size regarding amplitudes of RF pulses which are to be applied in a first traversal scanning; perform the first traversal scanning according to the first start value, the first end value and the first step size with a fixed time-domain length of the RF pulses, so as to obtain FID signal values corresponding to different RF pulse amplitudes in the first traversal scanning, wherein the FID signal values obtained in the first traversal scanning constitute a first FID signal set having an uptrend segment and a downtrend segment; perform a traversal parameter setting for determining a n-th start value, a n-th end value and a n-th step size regarding amplitudes of RF pulses which are to be applied in a n-th traversal scanning, wherein n is a positive integer greater than or equal to 2, the n-th start value is a RF pulse amplitude corresponding to an FID signal value of an uptrend segment of a (n-1)-th FID signal set obtained in a (n-1)-th traversal scanning, the n-th end value is a RF pulse amplitude corresponding to an FID signal value of a downtrend segment of the (n-1)-th FID signal set, the n-th start value is greater than or equal to a (n-1)-th start value of the (n-1)-th traversal scanning, the n-th end value is less than or equal to a (n-1)-th end value of the (n-1)-th traversal scanning, and the n-th step size is less than a (n-1)-th step size of the (n-1)-th traversal scanning; perform the n-th traversal scanning according to the n-th start value, the n-th end value and the n-th step size with the fixed time-domain length of the RF pulses, so as to obtain FID signal values corresponding to different RF pulse amplitudes in the n-th traversal scanning, wherein the FID signal values obtained in the n-th traversal scanning constitute a n-th FID signal set having a corresponding uptrend segment and a corresponding downtrend segment; determine whether the n-th traversal scanning is a last traversal scanning according to a default end condition; and if the n-th traversal scanning is determined to be the last traversal scanning, determine a linear relationship between a flip angle and a RF pulse amplitude according to a 90o flip angle and a corresponding RF pulse amplitude, wherein the RF pulse amplitude corresponding to the angle 90o flip angle is obtained from a RF pulse amplitude corresponding to a maximum FID signal value in the last traversal scanning.

The details of one or more embodiments of the subject matter described in the present disclosure are set forth in the accompanying drawings and description below. Other features, aspects, and advantages of the subject matter will become apparent from the description, the drawings, and the claims.

## BRIEF DESCRIPTION OF DRAWINGS

Features of the present disclosure are illustrated by way of example and not limited in the following figures, in which like numerals indicate like elements, in which:

FIG. 1 is a flowchart illustrating the procedures of a method of calibrating a radio frequency (RF) power of a magnetic resonance imaging system according to an example of the present disclosure.
FIG. 2 is a schematic diagram of a curve of an evaluation function for calibrating a RF power of a magnetic resonance imaging system.
FIG. 3 is a schematic diagram of a relationship between a flip angle and a RF pulse amplitude in a field of view (FOV).
FIG. 4 is a flowchart illustrating the procedures of a scanning method for a magnetic resonance imaging system according to an example of the present disclosure.
FIG. 5 is a hardware architecture diagram of a device for calibrating a RF power of a magnetic resonance imaging system according to an example of the present disclosure.
FIG. 6 is a block diagram of a control logic for calibrating a RF power of a magnetic resonance imaging system according to an example of the present disclosure.

## DETAILED DESCRIPTION

In a magnetic resonance imaging (MRI) system, a RF excitation field may be applied to obtain a magnetic resonance imaging information, such that a net magnetic moment formed by spin protons may have a certain flip angle. The RF excitation field may be provided by a RF system of the MRI system. In some implementations, the RF system of the MRI system may include a RF transmission unit, a RF amplifier, a RF transmission coil, a RF reception coil, and a RF reception unit. For a single scanning, the RF transmission unit may output a RF pulse signal having a specific center frequency, bandwidth, amplitude and phase; the RF amplifier may perform a power amplification on the RF pulse signal outputted by the RF transmission unit; and the RF transmission coil may receive the RF power outputted by the RF amplifier for generating a RF excitation field to make a net magnetic moment formed by spin protons have a certain flip angle. After stopping transmitting the RF pulse signal, a magnetic resonance signal, i.e., a free induction decay (FID) signal, is generated. The RF reception coil may receive the magnetic resonance signal, and then the magnetic resonance signal is processed by the RF reception unit in order to obtain imaging original data. A magnetic resonance medical image may be reconstructed based on the imaging original data. After stopping transmitting the RF pulse signal, a delay time may be set, and then the FID signal may be received.

In some implementations, to obtain an accurate flip angle, calibrating a RF transmission power is performed on a RF system. The calibration may be performed during a calibration period of the entire system, and the calibration method may specifically include the following steps: selecting a designated RF pulse waveform, and applying a RF pulse having a designated frequency and a certain amplitude; continuously incrementing the amplitude of the RF pulse, and receiving a FID signal generated during a corresponding RF receiving period until a whole range for the pulse amplitude is traversed or until the received FID signal is at a zero position; and recording RF pulse amplitudes corresponding to a maximum value and a minimum value of the FID signal during the RF receiving period. A RF pulse amplitude corresponding to a 90° flip angle is the RF pulse amplitude for obtaining the maximum value of the FID signal, a RF pulse amplitude corresponding to a 180° flip angle is the RF pulse amplitude for obtaining the minimum value of the FID signal (i.e., the FID signal is zero), and RF pulse amplitudes corresponding to other flip angles may be obtained by curve fitting. Therefore, a correspondence relationship between the flip angle and the RF pulse amplitude may be obtained after calibration, and the RF pulse amplitude corresponding to a designated flip angle may be determined according to the correspondence relationship.

The flip angle of the net magnetic moment formed by spin protons may be calculated according to the following formula:

$$\alpha = \gamma B_1 t_p$$

Herein. $\alpha$ represents a RF flip angle, $\gamma$ represents a Gyromagnetic ratio constant, $B_1$ represents an intensity of the RF transmission field, and $t_p$ represents a duration for applying the RF transmission field. The duration for applying the RF transmission field $t_p$ is the same as a time-domain length of the applied RF pulses. In a case that the time-domain length of the RF pulses is fixed, the size of the flip angle is mainly determined based on the intensity of the RF transmission field $B_1$. The intensity of the RF transmission field $B_1$ may be determined based on a current outputted by the RF amplifier, that is to say, it is determined based on the output power of the RF amplifier. Therefore, in a case that the time-domain length $t_p$ of the applied RF pulses is fixed, the output power of the RF amplifier may be adjusted by adjusting the RF pulse amplitude, such that the accurate RF flip angle $\alpha$ may be obtained.

The present disclosure provides a method of calibrating a RF power of a magnetic resonance imaging system. With a fixed time-domain length $t_p$ of the RF pulses, a RF pulse amplitude having a larger step size increment may be selected to perform the current traversal scanning, so as to obtain FID signal values corresponding to different RF pulse amplitudes. Then, in next traversal scanning, the larger step size may be scaled down to a smaller step size, and a start value and an end value regarding amplitudes of the RF pulses in the traversal scanning are re-determined to narrow a range for the next traversal scanning, which may quickly and accurately determine a RF pulse amplitude corresponding to a 90° flip angle.

A linear relationship between a flip angle and a RF pulse amplitude may be obtained according to the 90° flip angle and its corresponding RF pulse amplitude. The method may perform a calibration for a RF power quickly and effectively, which is convenient to provide more accurate calibration results to different subjects, thereby further obtaining better imaging quality.

Hereinafter, exemplary examples $\bar{B}_0$ of the present disclosure will be described in detail with reference to the accompanying drawings in order to make the above objectives, features, and advantages of the present disclosure more comprehensible.

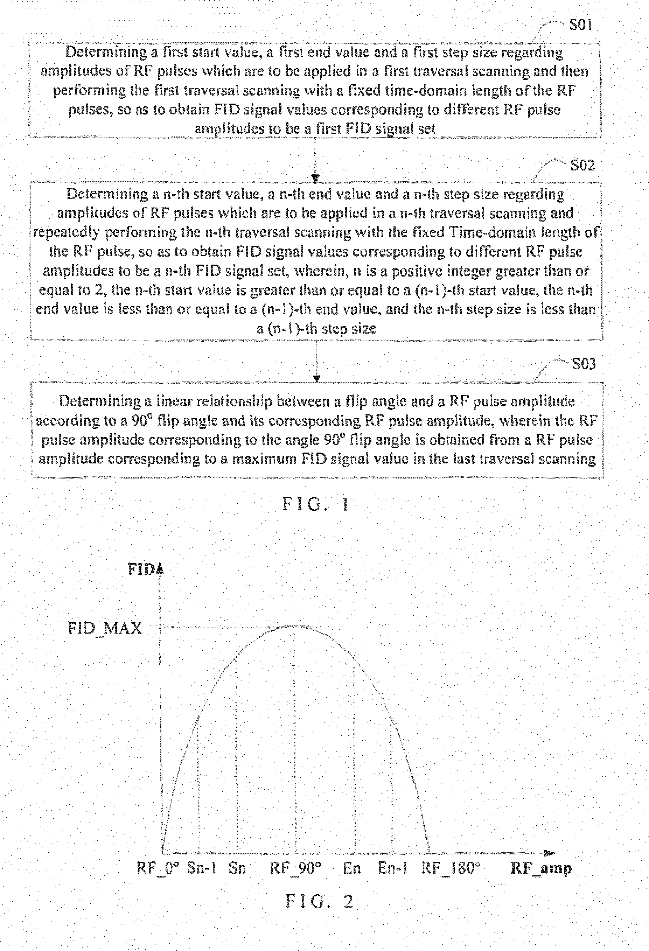

FIG. 1 is a flowchart illustrating the procedures of a method for calibrating a radio frequency (RF) power of a magnetic resonance imaging system according to an example of the present disclosure. The method may include the following blocks S01-S03.

At block S01, a first start value, a first end value and a first step size regarding amplitudes of RF pulses which are to be applied in a first traversal scanning are determined. With a fixed time-domain length of the RF pulses, the first traversal scanning is performed to obtain FID signal values corresponding to different RF pulse amplitudes to be a first FID signal set. All of the FID signal values may constitute the first FID signal set having an uptrend segment and a downtrend segment.

At this block, when the first traversal scanning is performed, the time-domain length of the RF pulses is basically fixed. The RF pulse amplitude may use the first start value as a starting point, and may be gradually incremented by the first step size until reaching the first end value as an ending point. The first start value, the first end value and the first step size may be determined by empirical values. The first step size is greater than the step sizes used in the subsequent traversal scanning, and it may cause the first traversal scanning is consisting of less scans than that of the subsequent traversal scanning. For each scanning, a RF pulse having a fixed frequency and a certain amplitude is applied to generate a RF excitation field for obtaining a flip angle corresponding to the certain amplitude.

For the convenience of description, in the present disclosure, a RF pulse amplitude corresponding to a certain flip angle is denoted as RF_amp. For example, RF_0° represents the RF pulse amplitude corresponding to a 0° flip angle, RF_90° represents the RF pulse amplitude corresponding to a 90° flip angle, and RF_180° represents the RF pulse amplitude corresponding to a 180° flip angle, etc. After stopping transmitting the RF pulse having the certain RF pulse amplitude, the FID signal value corresponding to the certain RF pulse amplitude is obtained.

FIG. 2 is a schematic diagram of a curve of an evaluation function for calibrating a RF power of a magnetic resonance imaging system, wherein the horizontal axis represents the RF pulse amplitude RF_amp, and the vertical axis represents FID. For a normally-operating magnetic resonance imaging system, the obtained FID signal value corresponding to RF_90° is the maximum value FID_MAX, the obtained FID signal values are gradually incremented from RF_0° to RF_90°, and the obtained FID signal values are successively decremented from RF_90° to RF_180°. When performing the first traversal scanning, the first start value of the RF pulse amplitude may be set to be close to RF_0° and the first end value of the RF pulse amplitude may be set to be close to RF_180° based on empirical values. Therefore, after traversal scanning, all of the obtained FID signal values may constitute an uptrend segment and a downtrend segment, which may be denoted as the first FID signal set. In the uptrend segment, the FID signal values are continuously increasing from the beginning to a peak, i.e., an inflection point. In the downtrend segment, the FID signal values are continuously decreasing from the inflection points to the end.

The above evaluation function is only applied to a normally-operating magnetic resonance imaging system. To exclude the case of an abnormally-operating magnetic resonance imaging system, whether a number of inflection points of an FID signal set is greater than 1 is determined after performing the traversal scanning. For example, the determination can be based on a result of determining whether a plurality of uptrend segments and/or downtrend segments exist in the FID signal set. If the plurality of uptrend segments and/or downtrend segments exist in the FID signal set, the number of infection points of the FID signal set is determined to be greater than 1. If the number of inflection points of the first FID signal set is greater than 1, subsequent traversal scanning is terminated and an associated error process may be performed. If the number of infection points of the FID signal set is determined to be no more than 1, the procedures of FIG. 1 proceed to block S02.

At block S02, a n-th start value, a n-th end value and a n-th step size regarding amplitudes of RF pulses which are to be applied in a n-th traversal scanning are determined. With a fixed time-domain length of the RF pulses, the n-th traversal scanning is repeatedly performed to obtain FID signal values corresponding to different RF pulse amplitudes to be a n-th FID signal set, wherein, n is a positive integer greater than or equal to 2, the n-th start value is a RF pulse amplitude corresponding to a FID signal value of an uptrend segment of a (n-1)-th FID signal set, the n-th end value is a RF pulse amplitude corresponding to a FID signal value of a downtrend segment of the (n-1)-th FID signal set, the n-th start value is greater than or equal to a (n-1)-th start value, the n-th end value is less than or equal to a (n-1)-th end value, and the n-th step size is less than a (n-1)-th step size. With the fixed time-domain length of the RF pulses, the FID signal values corresponding to different RF pulse amplitudes obtained by performing the n-th traversal scanning may constitute the n-th FID signal set having an uptrend segment and a downtrend segment.

At this block, the traversal scanning is repeatedly performed until the 90° RF pulse amplitude RF_90° corresponding to the maximum value of the FID signal value is obtained. For each traversal scanning, the range and the step size of RF pulse amplitude in current traversal scanning are smaller than the range and the step size of RF pulse amplitude in its previous traversal scanning, respectively. Through continuously narrowing the range and the step size of the RF pulse amplitude, an overall number of scans in one traversal scanning may be reduced, which may enable to obtain calibration results more quickly. As shown in FIG. 2, the start value Sn of the RF pulse amplitude in a current traversal scanning is shifted behind the start value Sn-1 of the RF pulse amplitude in its previous traversal scanning, and the end value En of the RF pulse amplitude in current traversal scanning is shifted ahead the end value En-1 of the RF pulse amplitude in its previous traversal scanning. Therefore, the range for the RF pulse amplitude in the current traversal scanning is narrowed.

Specifically, during each traversal scanning, when determining the range for the RF pulse amplitude of the current traversal scanning (i.e., when determining the start value and the end value), RF pulse amplitudes corresponding to the FID signal values may be selected from the uptrend segment and the downtrend segment of the FID signal set obtained in the previous traversal scanning, respectively, to ensure that the range for the RF pulse amplitude in the current traversal scanning is smaller than the range for the RF pulse amplitude in the previous traversal scanning. For example, the start value of the RF pulse amplitude in the current traversal scanning is shifted behind the start value of the RF pulse amplitude in the previous traversal scanning, and the end value of the RF pulse amplitude in the current traversal scanning is shifted ahead the end value of the RF pulse amplitude in the previous traversal scanning, thereby reducing the range for the RF pulse amplitude in the traversal scanning.

A variety of methods may be adopted for determining the start value and the end value in the current traversal scanning. For example, the start value and the end value may be scaled down according to a fixed step size or may be proportionally scaled down. In another example, the RF pulse amplitude of the last scanning point of the uptrend segment may be selected as the start value of the current traversal scanning, and the RF pulse amplitude of the first scanning point of the downtrend segment may be selected as the end value of the current traversal scanning. In a particular example, the start value of the current traversal scanning is a RF pulse amplitude corresponding to a previous scanning point of a maximum FID signal value of the FID signal set in the previous traversal scanning, and the end value of the current traversal scanning is a RF pulse amplitude corresponding to a next scanning point of the maximum FID signal value of the FID signal set in the previous traversal scanning. Therefore, it may ensure that the narrowed range for the RF pulse amplitude falls on both sides of the maximum FID signal value, which may improve speed and accuracy of the next traversal scanning.

During each traversal scanning, when determining the variation of the step size of the RF pulse amplitude of the current traversal scanning, a step size that is smaller than the step size used in the previous traversal scanning may be selected. Therefore, a more accurate scanning may be performed in a smaller range. A variety of methods may be adopted for determining the step size in the current traversal scanning. In an example, the step size in the current traversal scanning may be obtained by scaling down the step size in the previous traversal scanning proportionally. In another example, the step size in the current traversal scanning may be obtained by scaling down the step size in the previous traversal scanning according to a predetermined step size difference.

Similar to the first traversal scanning, FID signal values corresponding to different RF pulse amplitude may be obtained during each traversal scanning. After performing each traversal scanning, all of the obtained FID signal values may constitute an uptrend segment and a downtrend segment to be denoted as the n-th FID signal set.

After performing a plurality of traversal scanning, the traversal scanning is terminated. Since the step size used in the last traversal scanning is the smallest, the RF pulse amplitude corresponding to the maximum FID signal value obtained in the last traversal scanning may be considered as the RF pulse amplitude of the 90° flip angle. The number of the traversal scanning may be a predetermined value, or may be decided by determining the step size. For example, after performing each traversal scanning, determining whether the step size in the current traversal scanning is less than or equal to a predetermined minimum step size. If yes, then the current traversal scanning is the last traversal scanning. The predetermined minimum step size may be determined based on empirical values. The smaller the step size, the more accurate the obtained maximum FID signal value.

Similar to the first traversal scanning, to exclude the case of the abnormally-operating magnetic resonance imaging system, whether a number of inflection points of the FID signal set in the current traversal scanning is greater than 1 is determined after performing each traversal scanning, e.g., by determining whether a plurality of uptrend segments and/or downtrend segments exist in the FID signal set. If the number of inflection points of the FID signal set in the current traversal scanning is greater than 1, subsequent traversal scanning is terminated and an associated error process is performed. Otherwise, if the number of inflection points of the FID signal set in the current traversal scanning is no more than 1, the procedures of FIG. 1 proceed to block S03.

At block S03, a linear relationship between a flip angle and a RF pulse amplitude is obtained according to a 90° flip angle and its corresponding RF pulse amplitude, wherein the RF pulse amplitude corresponding to the angle 90° flip angle is obtained from a RF pulse amplitude corresponding to a maximum FID signal value in the last traversal scanning.

At this block, the linear relationship between the flip angle and the RF pulse amplitude may be obtained based on the 90° flip angle and its corresponding RF pulse amplitude. The maximum FID signal value obtained from the last traversal scanning is the RF pulse amplitude corresponding to the 90° flip angle, and thus the linear relationship between the calibrated flip angle and the RF pulse amplitude may be obtained, which may be used for determining subsequent RF pulse amplitudes corresponding to designated flip angles. When determining the relationship between the flip angles and the RF pulse amplitudes, it may be obtained based on the 90° flip angle and its corresponding RF pulse amplitude by using a relationship between a field of view (FOV) RF flip angle $\alpha$ and a spectroscopy RF pulse amplitude.

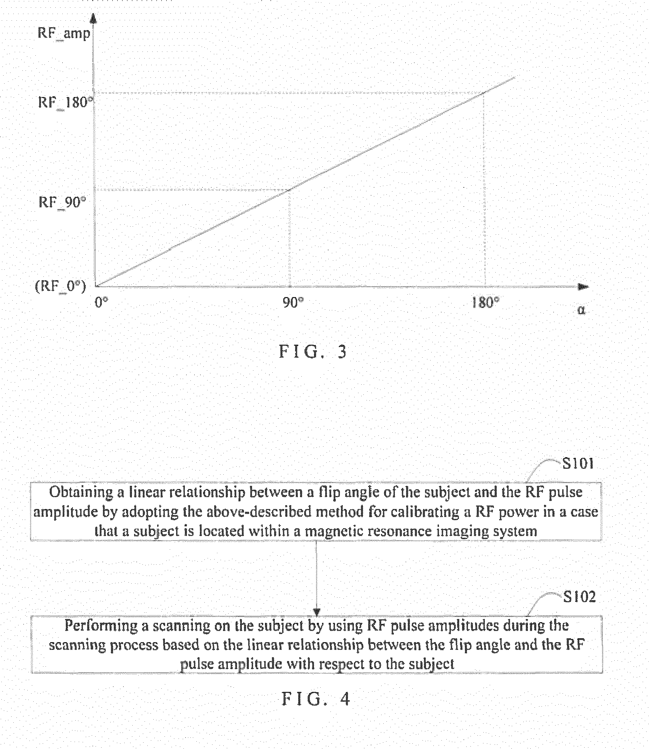

For example, as shown in FIG. 3, the horizontal axis represents the flip angle $\alpha$, and the vertical axis represents the RF pulse amplitude RF_amp. The relationship between the RF flip angle $\alpha$ and the spectroscopy RF pulse amplitude RF_amp in a FOV may be expressed by the following formula:

$$RF\_amp = k * \alpha$$

Herein, k represents a proportional constant determined based on the 90° flip angle and its corresponding RF pulse amplitude.

At this point, calibrating a RF power of a magnetic resonance imaging system in the example of the present disclosure is completed, thereby obtaining a linear relationship between the calibrated flip angle and the RF pulse amplitude.

The above obtained linear relationship between the calibrated flip angle and the RF pulse amplitude may be used for providing the RF pulse amplitudes used in actual scanning. However, individual differences exist between different subjects. For example, differences exist in weight, stature, portion to be scanned, and positioning during scanning, which may affect the duration of the RF excitation field and the RF pulse.

If the same linear relationship between the flip angle and the RF pulse amplitude is adopted for providing RF pulse amplitudes used in scanning of different subjects, it may lead to deviations in the flip angle, which may further affect imaging quality. To address this, a scanning method for a magnetic resonance imaging system is provided in the present disclosure, as shown in FIG. 4.

FIG. 4 is a flowchart illustrating the procedures of a scanning method for a magnetic resonance imaging system according to an example of the present disclosure. The scanning method may include the following blocks.

At block S101, in a case that a subject is located within a magnetic resonance imaging system, the above-described method for calibrating a RF power including the blocks S01-S03 may be adopted for obtaining a linear relationship between a flip angle and the RF pulse amplitude with respect to the subject.

At block S102, a scanning is performed on the subject, and the RF pulse amplitudes during the scanning process are obtained by the linear relationship between the flip angle and the RF pulse amplitude with respect to the subject.

That is to say, before a specific scanning is performed on each subject located within the magnetic resonance imaging system, the method of calibrating a RF power of the magnetic resonance imaging system of the present disclosure may be adopted for obtaining the exclusive linear relationship between the flip angle and the RF pulse amplitude exclusively for the subject. Therefore, when performing a scanning, the RF pulse amplitudes may be determined according to the exclusive linear relationship between the flip angle and the RF pulse amplitude exclusively for the subject, which is convenient to provide more accurate calibration results to different subjects, thereby further obtaining better imaging quality.

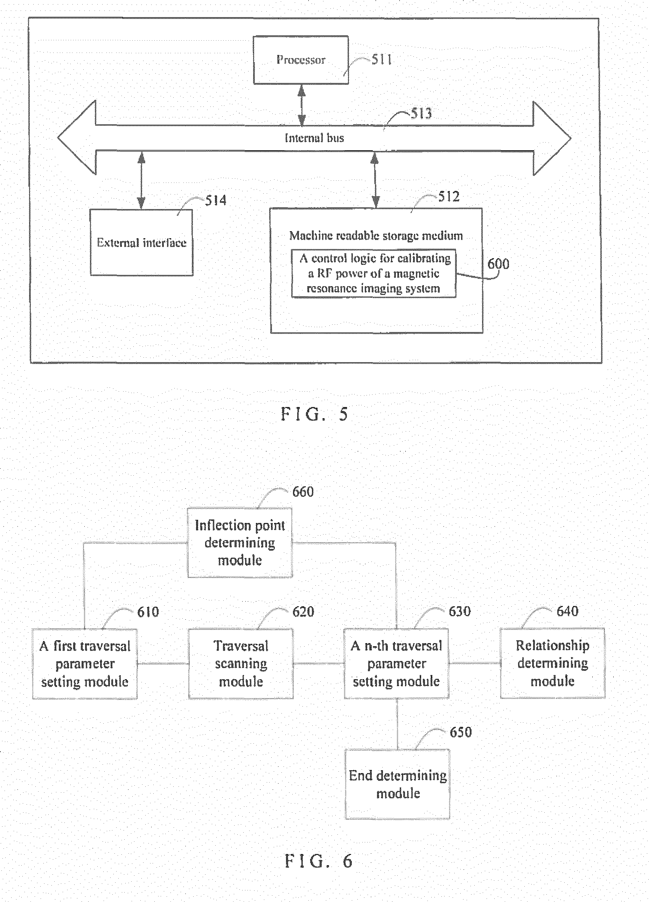

In accordance with the above-described method for calibrating a RF power, a device for calibrating a RF power of a magnetic resonance imaging system is provided in the present disclosure. FIG. 5 is a hardware architecture diagram of a device for calibrating a RF power of a magnetic resonance imaging system according to an example of the present disclosure. As shown in FIG. 5, the device for calibrating a RF power may include a processor 511 and a machine readable storage medium 512, wherein the processor 511 is connected to the machine readable storage medium 512 through an internal bus 513. In other possible implementations, the device for calibrating a RF power may further include an external interface 514 for communicating with other devices or components.

In different examples, the machine readable storage medium 512 may be Radom Access Memory (RAM), volatile memory, non-volatile memory, flash memory, storage drives (such as, a hard drive), solid state drive, any type of storage disks (such as, CD-ROM, DVD, etc.), or similar storage medium, or a combination thereof.

In an example, the machine readable storage medium 512 may be used for storing machine readable instructions corresponding to a control logic 600 for calibrating a RF power of a magnetic resonance imaging system. FIG. 6 is a block diagram $\overline{B}_0$ of a control logic for calibrating a RF power of a magnetic resonance imaging system according to an example of the present disclosure. As shown in FIG. 6, the control logic 600 may include a first traversal parameter setting module 610, a traversal scanning module 620, a n-th traversal parameter setting module 630, and a relationship determining module 640.

The first traversal parameter setting module 610 is used for determining a first start value, a first end value and a first step size regarding amplitudes of RF pulses which are to be applied in a first traversal scanning.

The traversal scanning module 620 is used for performing the i-th traversal scanning according to the i-th traversal parameters, so as to obtain FID signal values corresponding to different RF pulse amplitudes with a fixed time-domain length of the RF pulses, wherein all of the FID signal values constitute an i-th FID signal set. Herein, i is an integer greater than or equal to 1, and the i-th FID signal set has an uptrend segment and a downtrend segment.

The n-th traversal parameter setting module 630 is used for determining a n-th start value, a n-th end value and a n-th step size regarding amplitudes of RF pulses which are to be applied in a n-th traversal scanning, wherein n is a positive integer greater than or equal to 2, the n-th start value is a RF pulse amplitude corresponding to a FID signal value of an uptrend segment of a (n-1)-th FID signal set, the n-th end value is a RF pulse amplitude corresponding to a FID signal value of a downtrend segment of the (n-1)-th FID signal set, the n-th start value is greater than or equal to a (n-1)-th start value, the n-th end value is less than or equal to a (n-1)-th end value, and the n-th step size is less than a (n-1)-th step size. In an example, the n-th step size may be obtained by subtracting a predetermined step size difference from the (n-1)-th step size, or the n-th step size may be obtained by scaling down the (n-1)-th step size proportionally. In an example, the n-th start value may be a RF pulse amplitude corresponding to a previous scanning point of a maximum FID signal value in the (n-1)-th FID signal set; and the n-th end value may be a RF pulse amplitude corresponding to a next scanning point of the maximum FID signal value in the (n-1)-th FID signal set.

The relationship determining module 640 is used for determining a linear relationship between a flip angle and a RF pulse amplitude according to a 90° flip angle and its corresponding RF pulse amplitude, wherein the RF pulse amplitude corresponding to the angle 90° flip angle is obtained from a RF pulse amplitude corresponding to a maximum FID signal value in the last traversal scanning.

In another example, as shown in FIG. 6, the control logic 600 may further include an end determining module 650. The end determining module 650 is used for determining whether the n-th step size is less than or equal to a predetermined minimum step size, or for determining whether the traversal number n is greater than or equal to a predetermined threshold. If the end determining module 650 determines that the n-th step size is less than or equal to the predetermined minimum step size, or it determines that the traversal number n is greater than or equal to the predetermined threshold, the relationship determining module 640 may determine that the current traversal scanning is the last traversal scanning.

In still another example, as shown in FIG. 6, the control logic 600 may further include an inflection point determining module 660. The inflection point determining module 660 is used for determining whether a number of inflection points of the n-th FID signal set is greater than 1. If the inflection point determining module 660 determines that the number of inflection points of the n-th FID signal set is greater than 1, it means that a fault may occur in the magnetic resonance imaging system, which may need to exit calibration and perform appropriate fault tips.

The example below is implemented with software, which describes how the device for calibrating a RF power of the magnetic resonance imaging system runs the control logic 600. In this example, the control logic 600 of the present disclosure should be understood as machine readable instructions stored in the machine readable storage medium 512. When the processor 511 of the device for calibrating a RF power of the magnetic resonance imaging system executes the control logic 600, the processor 511 executes corresponding machine readable instructions of the control logic 600 stored in the machine readable storage medium 512 to:

> determine a first start value, a first end value and a first step size regarding amplitudes of RF pulses which are to be applied in a first traversal scanning; perform the first traversal scanning according to the first start value, the first end value and the first step size with a fixed time-domain length of the RF pulses, so as to obtain FID signal values corresponding to different RF pulse amplitudes, wherein all of the FID signal values constitute a first FID signal set having an uptrend segment and a downtrend segment; perform a traversal parameter setting for determining a n-th start value, a n-th end value and a n-th step size regarding amplitudes of RF pulses which are to be applied in a n-th traversal scanning, wherein n is a positive integer greater than or equal to 2, the n-th start value is a RF pulse amplitude corresponding to a FID signal value of an uptrend segment of a (n-1)-th FID signal set, the n-th end value is a RF pulse amplitude corresponding to a FID signal value of a downtrend segment of the (n-1)-th FID signal set, the n-th start value is greater than or equal to a (n-1)-th start value, the n-th end value is less than or equal to a (n-1)-th end value, and the n-th step size is less than a (n-1)-th step size; perform the n-th traversal scanning according to the n-th start value, the n-th end value and the n-th step size with the fixed time-domain length of the RF pulses, so as to obtain FID signal values corresponding to different RF pulse amplitudes, wherein all of the FID signal values constitute a n-th FID signal set having an uptrend segment and a downtrend segment; determine the n-th traversal scanning to be a last traversal scanning according to a default end condition, otherwise, re-perform the traversal parameter setting to continue a next traversal scanning; and determine a linear relationship between a flip angle and a RF pulse amplitude according to a 90° flip angle and its corresponding RF pulse amplitude, wherein the RF pulse amplitude corresponding to the angle 90° flip angle is obtained from a RF pulse amplitude corresponding to a maximum FID signal value in the last traversal scanning.

According to an example, the n-th step size is obtained by subtracting a predetermined step size difference from the (n-1)-th step size. According to another example, the n-th step size is obtained by scaling down the (n-1)-th step size proportionally.

According to an example, when determining whether a n-th traversal scanning is the last traversal scanning according to said default end condition, said machine readable instructions further cause the processor to: determine whether the n-th step size is less than or equal to a predetermined minimum step size; and determine that a current traversal scanning is the last traversal scanning if the n-th step size is less than or equal to the predetermined minimum step size.

According to another example, when determining whether the n-th traversal scanning is a last traversal scanning according to said default end condition, said machine readable instructions further cause the processor to: determine whether n is greater than or equal to a predetermined threshold; and determine that the current traversal scanning is the last traversal scanning if n is greater than or equal to the predetermined threshold.

According to an example, the n-th start value is a RF pulse amplitude corresponding to a previous scanning point of a maximum FID signal value in the (n-1)-th FID signal set; and the n-th end value is a RF pulse amplitude corresponding to a next scanning point of the maximum FID signal value in the (n-1)-th FID signal set.

According to an example, after performing the i-th traversal scanning, and i is a positive integer greater than or equal to I, said machine readable instructions further cause the processor to: determine whether a number of inflection points of the i-th FID signal set is greater than 1; and terminate the traversal scanning if the number of inflection points of the i-th FID signal set is greater that 1.

The above are only preferred examples of the present disclosure is not intended to limit the disclosure within the spirit and principles of the present disclosure, any changes made, equivalent replacement, or improvement in the protection of the present disclosure should contain within the range.

The methods, processes and units described herein may be implemented by hardware (including hardware logic circuitry), software or firmware or a combination thereof. The term 'processor' is to be interpreted broadly to include a processing unit, ASIC, logic unit, or programmable gate array etc. The processes, methods and functional units may all be performed by the one or more processors; reference in this disclosure or the claims to a 'processor' should thus be interpreted to mean 'one or more processors'.

Further, the processes, methods and functional units described in this disclosure may be implemented in the form of a computer software product. The computer software product is stored in a storage medium and comprises a plurality of instructions for making a processor to implement the methods recited in the examples of the present disclosure.

The figures are only illustrations of an example, wherein the units or procedure shown in the figures are not necessarily essential for implementing the present disclosure. Those skilled in the art will understand that the units in the device in the example can be arranged in the device in the examples as described, or can be alternatively located in one or more devices different from that in the examples. The units in the examples described can be combined into one module or further divided into a plurality of sub-units.

Although the flowcharts described show a specific order $\overline{B}_0$ of execution, the order of execution may differ from that which is depicted. For example, the order of execution of two or more blocks may be changed relative to the order shown. Also, two or more blocks shown in succession may be executed concurrently or with partial concurrence. All such variations are within the scope of the present disclosure.

For simplicity and illustrative purposes, the present disclosure is described by referring mainly to an example thereof. In the above description, numerous specific details are set forth in order to provide a thorough understanding of the present disclosure. It will be readily apparent however, that the present disclosure may be practiced without limitation to these specific details. In other instances, some methods and structures have not been described in detail so as not to unnecessarily obscure the present disclosure.

As used herein, the terms "a" and "an" are intended to denote at least one of a particular element, the term "includes" means includes but not limited to, the term ''including" means including but not limited to, and the term "based on" means based at least in part on. Throughout the present disclosure, the word "comprise", or variations such as "comprises" or "comprising", will be understood to imply the inclusion of a stated element, integer or step size, or group of elements, integers or step sizes, but not the exclusion of any other element, integer or step size, or group of elements, integers or step sizes.

It will be appreciated by persons skilled in the art that numerous variations and/or modifications may be made to the above-described embodiments, without departing from the broad general scope of the present disclosure. The present embodiments are, therefore, to be considered in all respects as illustrative and not restrictive. Accordingly, other embodiments are within the scope of the following claims.

## Claims

1. A method of calibrating a radio frequency (RF) power of a magnetic resonance imaging system, the method comprising:

   determining a first start value, a first end value and a first step size regarding amplitudes of RF pulses which are to be applied in a first traversal scanning;
   performing the first traversal scanning according to the first start value, the first end value and the first step size with a fixed time-domain length of the RF pulses, so as to obtain free induction decay (FID) signal values corresponding to different RF pulse amplitudes in the first traversal scanning, wherein the FID signal values obtained in the first traversal scanning constitute a first FID signal set having an uptrend segment and a downtrend segment;
   performing a traversal parameter setting for determining a n-th start value, a n-th end value and a n-th step size regarding amplitudes of RF pulses which are to be applied in a n-th traversal scanning, wherein n is a positive integer greater than or equal to 2, the n-th start value is a RF pulse amplitude corresponding to an FID signal value of an uptrend segment of a (n-1)-th FID signal set obtained in a (n-1)-th traversal scanning, the n-th end value is a RF pulse amplitude corresponding to an FID signal value of a downtrend segment of the (n-1)-th FID signal set, the n-th start value is greater than or equal to a (n-1)-th start value of the (n-1)-th traversal scanning, the n-th end value is less than or equal to a (n-1)-th end value of the (n-1)-th traversal scanning, and the n-th step size is less than a (n-1)-th step size of the (n-1)-th traversal scanning;

performing the n-th traversal scanning according to the n-th start value, the n-th end value and the n-th step size with the fixed time-domain length of the RF pulses, so as to obtain FID signal values corresponding to different RF pulse amplitudes in the n-th traversal scanning, wherein the FID signal values obtained in the n-th traversal scanning constitute a n-th FID signal set having a corresponding uptrend segment and a corresponding downtrend segment;

determining whether the n-th traversal scanning is a last traversal scanning according to a default end condition; and

if the n-th traversal scanning is determined to be the last traversal scanning according to the default end condition, determining a linear relationship between a flip angle and a RF pulse amplitude according to a 90" flip angle and a corresponding RF pulse amplitude, wherein the RF pulse amplitude corresponding to the 90° flip angle is obtained from a RF pulse amplitude corresponding to a maximum FID signal value in the last traversal scanning.

2. The method according to claim 1, wherein determining the n-th step size comprises subtracting a predetermined step size difference from the (n-1)-th step size.

3. The method according to claim 1, wherein determining the n-th step size comprises scaling down the (n-1)-th step size proportionally.

4. The method according to claim I, wherein determining whether the n-th traversal scanning is a last traversal scanning according to a default end condition comprises determining whether the n-th step size is less than or equal to a predetermined minimum step size, and

wherein the method further comprises determining that the n-th traversal scanning is the last traversal scanning if the n-th step size is determined to be less than or equal to the predetermined minimum step size.

5. The method according to claim I, wherein determining whether the n-th traversal scanning is a last traversal scanning according to a default end condition comprises determining whether n is greater than or equal to a predetermined threshold, and

wherein the method further comprises determining that the n-th traversal scanning is the last traversal scanning if n is determined to be greater than or equal to the predetermined threshold.

6. The method according to claim 1, wherein the n-th start value is a RF pulse amplitude corresponding to a previous scanning point of a maximum FID signal value in the (n-1)-th FID signal set, and

wherein the n-th end value is a RF pulse amplitude corresponding to a next scanning point of the maximum FID signal value in the (n-1)-th FID signal set.

7. The method according to claim 1, further comprising:

determining whether a number of inflection points of an i-th FID signal set obtained from an i-th traversal scanning is greater than I, wherein i is a positive integer greater than or equal to 1, the inflection point connects an uptrend segment and a downtrend segment of the i-th FID signal set; and

terminating subsequent traversal scanning if the number of inflection points of the i-th FID signal set is determined to be greater than 1.

8. The method according to claim 1, further comprising:

if the n-th traversal scanning is determined not to be the last traversal scanning according to the default end condition, re-performing the traversal parameter setting to continue a next (n+1)-th traversal scanning.

9. A scanning method for a magnetic resonance imaging system, the method comprising:

obtaining a linear relationship between a flip angle and a RF pulse amplitude by adopting the method of claim I in a case that a subject is located in a magnetic resonance imaging system; and

performing a scanning to the subject by using a RF pulse amplitude determined based on the linear relationship.

10. A device for calibrating a RF power of a magnetic resonance imaging system, the device comprising:

a processor which invokes machine readable instructions corresponding to a control logic for calibrating a RF power stored on a storage medium and executes the machine readable instructions to:

determine a first start value, a first end value and a first step size regarding amplitudes of RF pulses which are to be applied in a first traversal scanning;

perform the first traversal scanning according to the first start value, the first end value and the first step size with a fixed time-domain length of the RF pulses, so as to obtain FID signal values corresponding to different RF pulse amplitudes in the first traversal scanning, wherein the FID signal values obtained in the first traversal scanning constitute a first FID signal set having an uptrend segment and a downtrend segment;

perform a traversal parameter setting for determining a n-th start value, a n-th end value and a n-th step size regarding amplitudes of RF pulses which are to be applied in a n-th traversal scanning, wherein n is a positive integer greater than or equal to 2, the n-th start value is a RF pulse amplitude corresponding to an FID signal value of an uptrend segment of a (n-1)-th FID signal set obtained in a (n-1)-th traversal scanning, the n-th end value is a RF pulse amplitude corresponding to an FID signal value of a downtrend segment of the (n-1)-th FID signal set, the n-th start value is greater than or equal to a (n-1)-th start value of the (n-1)-th traversal scanning, the n-th end value is less than or equal to a (n-1)-th end value of the (n-1)-th traversal scanning, and the n-th step size is less than a (n-1)-th step size of the (n-1)-th traversal scanning;

perform the n-th traversal scanning according to the n-th start value, the n-th end value and the n-th step size with the fixed time-domain length of the RF pulses, so as to obtain FID signal values corresponding to different RF pulse amplitudes in the n-th traversal scanning, wherein the FID signal values obtained in the n-th traversal scanning constitute a n-th FID signal set having a corresponding uptrend segment and a corresponding downtrend segment;

determine whether the n-th traversal scanning is a last traversal scanning according to a default end condition; and

if the n-th traversal scanning is determined to be the last traversal scanning, determine a linear relationship between a flip angle and a RF pulse amplitude according to a 90° flip angle and a corresponding RF pulse amplitude, wherein the RF pulse amplitude corresponding to the angle 90° flip angle is obtained from a RF pulse amplitude corresponding to a maximum FID signal value in the last traversal scanning.

**11.** The device according to claim 10, wherein the n-th step size is obtained by subtracting a predetermined step size difference from the (n-1)-th step size.

**12.** The device according to claim 10, wherein the n-th step size is obtained by scaling down the (n-1)-th step size proportionally.

**13.** The device according to claim 10, wherein the machine readable instructions cause the processor to determine whether the n-th traversal scanning to is a last traversal scanning according to a default end condition by determining whether the n-th step size is less than or equal to a predetermined minimum step size, and

wherein the machine readable instructions further cause the processor to determine that a current traversal scanning is the last traversal scanning if the n-th step size is determined to be less than or equal to the predetermined minimum step size.

**14.** The device according to claim 10, wherein the machine readable instructions cause the processor to determine whether the n-th traversal scanning to is a last traversal scanning according to a default end condition by determining whether n is greater than or equal to a predetermined threshold, and

wherein the machine readable instructions further cause the processor to determine that a current traversal scanning is the last traversal scanning if n is determined to be greater than or equal to the predetermined threshold.

**15.** The device according to claim 10, wherein the n-th start value is a RF pulse amplitude corresponding to a previous scanning point of a maximum FID signal value in the (n-1)-th FID signal set, and

wherein the n-th end value is a RF pulse amplitude corresponding to a next scanning point of the maximum FID signal value in the (n-1)-th FID signal set.

S01

Determining a first start value, a first end value and a first step size regarding amplitudes of RF pulses which are to be applied in a first traversal scanning and then performing the first traversal scanning with a fixed time-domain length of the RF pulses, so as to obtain FID signal values corresponding to different RF pulse amplitudes to be a first FID signal set

S02

Determining a n-th start value, a n-th end value and a n-th step size regarding amplitudes of RF pulses which are to be applied in a n-th traversal scanning and repeatedly performing the n-th traversal scanning with the fixed Time-domain length of the RF pulse, so as to obtain FID signal values corresponding to different RF pulse amplitudes to be a n-th FID signal set, wherein, n is a positive integer greater than or equal to 2, the n-th start value is greater than or equal to a (n-1)-th start value, the n-th end value is less than or equal to a (n-1)-th end value, and the n-th step size is less than a (n-1)-th step size

S03

Determining a linear relationship between a flip angle and a RF pulse amplitude according to a 90° flip angle and its corresponding RF pulse amplitude, wherein the RF pulse amplitude corresponding to the angle 90° flip angle is obtained from a RF pulse amplitude corresponding to a maximum FID signal value in the last traversal scanning

FIG. 1

FIG. 2

RF_amp

RF_180°

RF_90°

(RF_0°)

0°　　　　　　90°　　　　　　180°　　　α

FIG. 3

S101

Obtaining a linear relationship between a flip angle of the subject and the RF pulse amplitude by adopting the above-described method for calibrating a RF power in a case that a subject is located within a magnetic resonance imaging system

S102

Performing a scanning on the subject by using RF pulse amplitudes during the scanning process based on the linear relationship between the flip angle and the RF pulse amplitude with respect to the subject

FIG. 4

Processor — 511

513

Internal bus

514

External interface

512

Machine readable storage medium

A control logic for calibrating a RF power of a magnetic resonance imaging system

600

FIG. 5

660

Inflection point determining module

610

A first traversal parameter setting module

620

Traversal scanning module

630

A n-th traversal parameter setting module

640

Relationship determining module

650

End determining module

FIG. 6

14